# EUROPÄISCHE PATENTSCHRIFT

(11) **EP 3 024 310 B1**
(45) Veröffentlichungstag und Bekanntmachung des Hinweises auf die Patenterteilung: **07.06.2023**
(21) Anmeldenummer: 15003283.7
(22) Anmeldetag: 18.11.2015
(51) Int. Cl.: H05K 7/20, H02B 1/56

(54) **KLIMATISIERUNGSANORDNUNG**
AIR CONDITIONING ASSEMBLY
SYSTÈME DE CLIMATISATION

(30) Priorität: 24.11.2014 DE 102014017658
(43) Veröffentlichungstag der Anmeldung: 25.05.2016
(73) Patentinhaber: Friedrich Lütze GmbH, 71366 Weinstadt-Grossheppach (DE)
(72) Erfinder: Lang, Jürgen, 71640 Ludwigsburg (DE); Ghizelea, Virgil, 70372 Stuttgart (DE); Lack, Martin, 71397 Leutenbach (DE)
(74) Vertreter: Bartels und Partner, Patentanwälte

(56) Entgegenhaltungen:
- EP-A1- 2 124 518
- EP-A1- 2 685 798
- DE-A1-102012 100 974
- DE-B4-102009 054 011
- Stego Elektrotechnik Gmbh: "Kurzanleitung Stegojet Type SJ019", , 8. Juli 2013 (2013-07-08), XP055329611, Gefunden im Internet: URL:https://www.automationdirect.com/stati c/manuals/enclosurethermmgmt/sj019.pdf [gefunden am 2016-12-15]
- Stego Elektrotechnik Gmbh: "TECHNICAL DATASHEET Stegojet SJ019", , 18. Juni 2013 (2013-06-18), XP055329615, Gefunden im Internet: URL:http://docs-europe.electrocomponents.c om/webdocs/125d/0900766b8125d573.pdf [gefunden am 2016-12-15]
- Elexa Gmbh: "Einbaulüfter SJ019 - leicht, kompakt, leistungsstark", , 10. Juni 2013 (2013-06-10), XP055329821, Gefunden im Internet: URL:http://www.elexagmbh.de/dante-cms/app_ data/adam/repo/tempmedia/1481882570.EYWRDP DCEQKSNFATWGZPTMFEOYQUNLCY/5382_Einbauluef ter__SJ019_-2013.pdf [gefunden am 2016-12-16]

## Beschreibung

Die Erfindung betrifft eine Klimatisierungsanordnung, insbesondere Kühlanordnung, zumindest aufweisend einen Schaltschrank mit einer horizontal verlaufende Montagestege aufweisenden Trageinrichtung, an deren Vorderseite, die Schaltschranktüren zugewandt ist, zu klimatisierende elektrische und/oder elektronische Geräte in Etagen über- und nebeneinander angeordnet sind, wobei eine Luftfördereinrichtung vorgesehen ist, mit der auf der Rückseite der Trageinrichtung eine Luftströmung von oben nach unten erzwingbar ist, und wobei Teilluftströme der Luftströmung zwischen vertikal benachbarten Montagestegen hindurch zur Vorderseite der Montagestege und zu an der Vorderseite der Montagestege angebrachten, zu klimatisierenden Geräten gelangen.

Eine Klimatisierungsanordnung dieser Gattung ist aus dem Dokument DE 10 2009 054 011 B4 bekannt. Insbesondere in der industriellen Steuerungstechnik werden elektrische und/oder elektronische Geräte häufig in Schaltschränken oder Schaltkästen angeordnet. Die einzelnen Geräte entwickeln während des Betriebes eine zum Teil erhebliche Verlustwärme, was zu einer Temperaturerhöhung innerhalb des Schaltschranks führt. Damit die Funktionsfähigkeit der Geräte gewährleistet ist, darf die Temperatur einen Maximalwert nicht überschreiten. So können in den Geräten eingebaute Halbleiter-Bauelemente nur bis zu einer Bauelementtemperatur von beispielsweise 85 °C oder 125 °C funktionssicher betrieben werden.

Die aus der DE 10 2009 054 011 B4 bekannte Lösung ist als Kühlanordnung ausgelegt, bei der die an der Rückseite der Trageinrichtung der Geräte von oben nach unten verlaufende Luftströmung einen Kühlluftstrom bildet, dessen Temperatur mittels einer Luftkühlungseinrichtung, beispielsweise in Form eines Kältekompressors, auf eine gewünschte Temperatur eingestellt ist. Teilluftströme der Luftströmung, die durch Durchtrittsöffnungen zwischen den Montagestegen zur Vorderseite gelangen, umströmen die an den Montagestegen befindlichen, zu entwärmenden Geräte, vereinigen sich zu einem durch die Verlustwärme der Geräte erwärmten, an der Vorderseite aufsteigenden Luftstrom, der zum Eingang der Luftfördereinrichtung gelangt, so dass innerhalb des Schaltschranks ein Klimatisierungskreislauf gebildet ist, im Falle der bekannten Kühlanordnung in Form eines Kühlluftkreislaufs.

Bei der erwähnten bekannten Lösung sind Durchtrittsöffnungen zwischen den Montagestegen in "strategisch" gewählter Anordnung vorgesehen, um je nach Verteilung der an der Vorderseite angebrachten Geräte den Kühlluftstrom derart in Teilluftströme aufzuteilen, dass eine wirksame Entwärmung an den Geräten erreicht wird und es nicht zur Ausbildung örtlicher Wärmenester kommt. Wenn an der Vorderseite Geräte mit jeweils ähnlicher Verlustleistung in gleichmäßiger Verteilung angeordnet sind, können die Durchtrittsöffnungen auch derart angelegt sein, dass die Luftströmung auf der Vorderseite laminar gehalten wird, so dass Verwirbelungen aufgrund der auf der Vorderseite angeordneten Geräte vermindert werden und damit die Klimatisierung, insbesondere Entwärmung, der Geräte verbessert wird. Um die Luft der Teilluftströme auch in horizontaler Richtung zu verteilen, sieht die erwähnte bekannte Lösung auch die Möglichkeit vor, Luftleitelemente an den Durchtrittsöffnungen einzusetzen, um den betreffenden, hindurchtretenden Teilluftstrom in horizontaler und/oder vertikaler Richtung zu leiten. Trotz dieser Maßnahmen lässt die bekannte Lösung, was die Klimatisierungs-, insbesondere Kühlleistung anbelangt, vor allem dann noch Wünsche offen, wenn an den Montagestegen Geräte angeordnet sind, die im Vergleich zu anderen oder benachbarten Geräten eine wesentlich höhere Verlustwärme entwickeln.

Weitere Klimatisierungsanordnungen gehen aus der DE 10 2012 100 974 A1, der EP 2 685 798 A1 und der EP 2 124 518 A1 hervor.

Ausgehend von dem genannten Stand der Technik liegt der Erfindung daher die Aufgabe zugrunde, unter Beibehalten der Vorteile der bekannten Lösung, nämlich elektrische und/oder elektronische Geräte in funktionssicherer und platzsparender Weise in einem Schaltschrank zu integrieren und zu klimatisieren, dahingehend weiter zu verbessern, dass eine Klimatisierungsanordnung, insbesondere Kühlanordnung, geschaffen ist, die eine gleichmäßige Klimatisierung, insbesondere Entwärmung auch bei Vorhandensein von Geräten stark unterschiedlicher Verlustwärme gewährleistet. Eine dahingehende Aufgabe löst eine Klimatisierungsanordnung, die die Merkmale des Patentanspruchs 1 in seiner Gesamtheit aufweist.

Gemäß dem kennzeichnenden Teil des Anspruchs 1 sieht die Erfindung vor, dass für eine gezielte, bereichsweise Verstärkung der Klimatisierungswirkung an zumindest einer ausgewählten, einem zu klimatisierenden Gerät räumlich angeordneten Stelle eine die Strömungsgeschwindigkeit des betreffenden Teilluftstroms aktiv erhöhende Einrichtung vorgesehen sind; dass als jeweilige, die Strömungsgeschwindigkeit erhöhende Einrichtung ein elektrisch betreibbarer Lüfter vorgesehen ist; und dass die Temperatur der Umgebungszone der ausgewählten Geräte erkennende Temperatursensoren und eine die Leistung zugeordneter Lüfter in Abhängigkeit von der erkannten Zonentemperatur regelnde Steuereinrichtung vorgesehen sind. Dadurch ist für ausgewählte Geräte eine Intensiv-Klimatisierung, insbesondere Kühlung, erreichbar, so dass durch eine punktuell erfolgende, verstärkte Entwärmung die Bildung von Wärmenestern (sog. Hot-Spots) vermeidbar ist. Fener ist dadurch ein selbsttätiger, bedarfsangepasster und daher energetisch optimaler Betrieb möglich.

Es sind als jeweilige, die Strömungsgeschwindigkeit erhöhende Einrichtungen elektrisch betreibbare Lüfter vorgesehen. Gegenüber der Verbesserung der Kühlwirkung, die durch eine gerichtete Lüfterströmung erzeugbar ist, ist der durch den Lüfterbetrieb verursachte Verlustleistungseintrag vernachlässigbar, beispielsweise bei einer Leistungsaufnahme von in Frage kommenden Einbaulüftern von etwa 4 Watt.

Mit Vorteil können jeweilige Lüfter an Montagestegen unterhalb ausgewählter Geräte angeordnet sein, so dass diese bei einer an der Vorderseite aufsteigenden Luftströmung von unten her anströmbar und umströmbar sind. Bei bevorzugten Ausführungsbeispielen können die Zwischenräume zwischen benachbarten Montagestegen zumindest teilweise durch Verschlussteile geschlossen sein, wobei in diesen Durchtrittsöffnungen für Teilluftströme in räumlicher Zuordnung zu den zu klimatisierenden Geräten und zu jeweiligen Lüftern gebildet sind. Alternativ können jedoch die zwischen benachbarten Montagestegen freigelassenen Zwischenräume die Durchtrittsöffnung bilden.

Elektrische Leitungen der Verdrahtung der Geräte sowie die Anschlussleitungen jeweiliger Lüfter können, wie dies auch bei Verdrahtungen von nicht klimatisierten Schaltschränken üblich ist, über Verdrahtungskämme, die sich an den Zwischenraum zwischen Montagestegen begrenzenden Seitenrändern befinden, zu der die Verdrahtungsseite bildenden Rückseite der Trageinrichtung geführt sein.

Die Temperierung der Luftströmung, die von der beispielsweise als Querstromlüfter ausgebildeten Luftfördereinrichtung erzeugt ist und sich in Form eines Strömungsbandes entlang der Rückseite des Schaltschranks von oben nach unten bewegt, kann auf verschiedene Weise temperiert, insbesondere gekühlt, sein. Beispielsweise kann eine passive Kühlung durch einen Wärmeaustausch über die Schrankrückwand zur kühlen Außenluft vorgesehen sein. Mit besonderem Vorteil ist jedoch eine aktive Klimatisierung, insbesondere Kühlung, durch eine Luftkühlungseinrichtung vorgesehen, die, der Luftfördereinrichtung nachgeordnet, oberhalb des obersten Montagesteges angeordnet ist. Beispielsweise kann es sich dabei um den Verdampfer einer Kompressor-Kühlanlage handeln. Ebenso kann auch eine aktive Kühlung an der Schrankrückwand vorgesehen sein, beispielsweise in der Weise, dass diese als sog. "cold-plate" ausgebildet oder mit einer solchen in Verbindung ist, wobei ein derartiges Kühlelement innere Kühlschlangen aufweisen kann. Auch kann die Schrankrückwand für eine passive Kühlung an einer kühlen Gebäudewand anliegen oder eine solche kann selbst die Schrankrückwand bei einer rückseitig offenen Schrankbauweise bilden.

Nachstehend ist die Erfindung anhand der Zeichnung im Einzelnen erläutert. Es zeigen:
- Fig. 1: eine stark schematisch vereinfachte perspektivische Ansicht auf einen Schaltschrank mit einer Klimatisierungsanordnung gemäß dem Stand der Technik;
- Fig. 2: eine schematisch vereinfachte Seitenansicht des Schaltschranks von Fig. 1 gemäß dem Stand der Technik;
- Fig. 3: eine stark schematisch vereinfachte Draufsicht auf die Vorderseite der Trageinheit eines Schaltschranks mit einer Klimatisierungsanordnung gemäß einem Ausführungsbeispiel der Erfindung; und
- Fig. 4: eine Draufsicht auf eine Teilfläche der Trageinheit eines Schaltschranks mit einer erfindungsgemäßen Klimatisierungsanordnung.

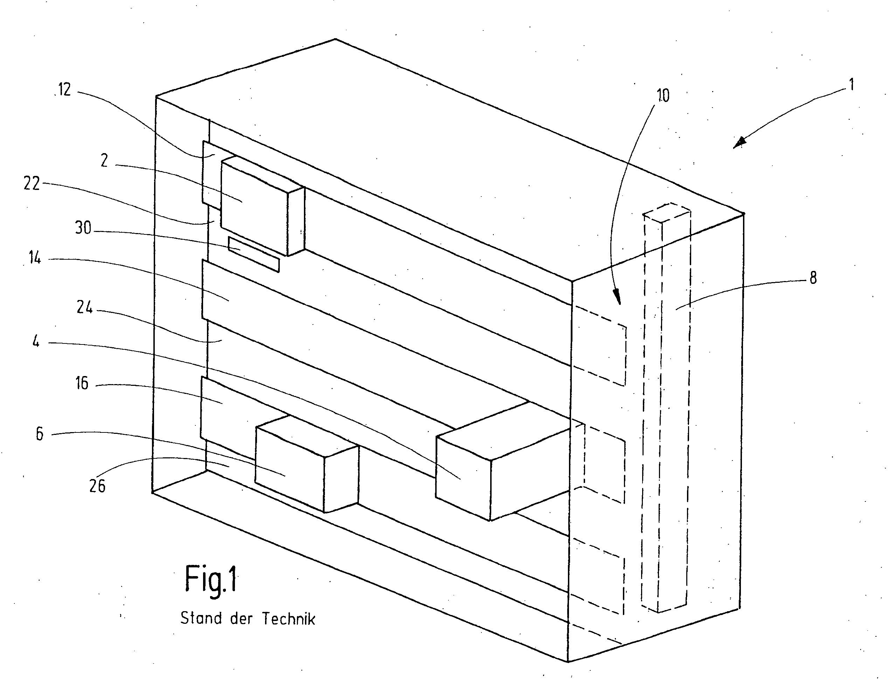

Die Fig. 1 zeigt eine perspektivische Ansicht auf einen dem Stand der Technik entsprechenden Schaltschrank 1, wie er für die Montage elektrischer und/oder elektronischer Geräte 2, 4, 6 wie beispielsweise Steuereinrichtungen, Sicherungen, Sensoren usw. beispielsweise in der industriellen Fertigungstechnik verwendet wird.

In dem Schaltschrank 1 ist eine nur schematisch dargestellte Trageinrichtung angeordnet, die im Ausführungsbeispiel aus zwei oder mehreren vertikal verlaufenden Tragschienen 8 und insgesamt drei im Wesentlichen horizontal verlaufenden Montagestegen 12, 14, 16 zusammengesetzt ist. Die Verbindung zwischen den Montagestegen 12, 14, 16 und den Tragschienen 8 kann über in der Fig. 1 nicht dargestellte Verbindungselemente, beispielsweise Bügel, erfolgen, wobei die Montagestege 12, 14, 16 in Richtung der in der Fig. 1 ansichtigen Vorderseite vor den Tragschienen 8 angeordnet sind. Die Tragschienen 8 und die Montageschienen 12, 14, 16 bilden einen Rahmen 10, der auch vormontiert werden kann und anschließend in den Schaltschrank 1 eingesetzt werden kann.

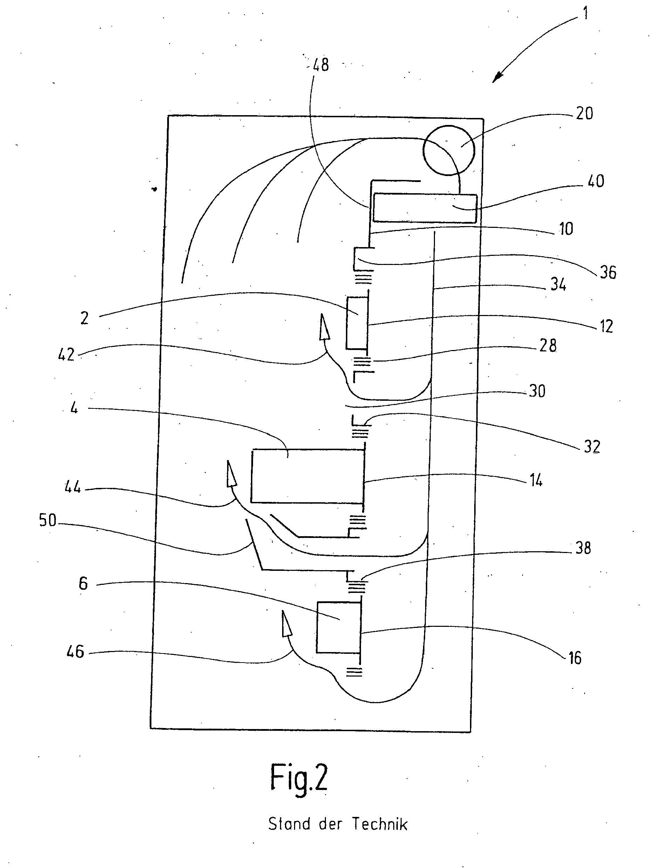

Auf der Vorderseite der Montagestege 12, 14, 16 und mithin der Vorderseite des Rahmens 10 sind die Geräte 2, 4, 6 in Etagen übereinander angeordnet, insbesondere an jeweils zugehörigen Montagestegen 12, 14, 16 vorzugsweise lösbar befestigt. Die Vorderseite des Schaltschanks 1 kann mit einer in der Fig. 1 aus Gründen der Übersichtlichkeit nicht dargestellten Tür verschließbar sein. Auf der Rückseite des Rahmens 10, insbesondere im Bereich der Tragschienen 8, ist mittels einer Luftfördereinrichtung 20 (Fig. 2) eine Luftströmung 34 erzwingbar, die im Wesentlichen von oben nach unten verläuft.

Die Stegzwischenräume zwischen den Montagestegen 12, 14, 16 sind mittels Verschlusselementen 22, 24, 26 mindestens teilweise verschließbar, wobei im Bereich dieser Stegzwischenräume auch elektrische Anschlussleitungen der Geräte 2, 4, 6 von der Vorderseite des Rahmens 10 auf die Rückseite geführt werden und die Verdrahtung und Kabelführung dementsprechend auf der Rückseite des Rahmens 10 verlaufen kann. Zu diesem Zweck können die Verschlusselemente 22, 24, 26 jeweils mehrteilig ausgebildet sein, insbesondere beispielsweise einen Verdrahtungskamm 28 (Fig. 2) und ein Deckelelement 32 aufweisen.

In dem Deckelelement 32 ist eine Durchtrittsöffnung 30 angeordnet, über welche kühlende Luft von der Rückseite auf die Vorderseite des Rahmens 10 hindurchtreten kann und dadurch gezielt dem Wärme erzeugenden Gerät 2 zuführbar ist. In der Ansicht der Fig. 1 ist lediglich die Durchtrittsöffnung 30 für das erste Gerät 2 sichtbar; dessen ungeachtet ist auch in dem zweiten Verschlusselement 24 und in dem dritten Verschlusselement 26 jeweils eine Durchtrittsöffnung für das zweite bzw. dritte Gerät 4, 6 angeordnet.

Die Fig. 2 zeigt eine Seitenansicht eines derartigen, dem Stand der Technik (DE 10 2009 054 011 B4) entsprechenden Schaltschranks 1. Die Luftfördereinrichtung 20 ist als Querstromlüfter oder Walzenlüfter ausgebildet und saugt die Luft im oberen Bereich des Inneren des Schaltschranks 1 an und fördert sie auf die Rückseite des Rahmens 10. Im dargestellten Beispiel weist der Schaltschrank 1 eine Luftkühlungseinrichtung 40 auf, wobei in der Fig. 2 lediglich ein Verdampfer der Luftkühlungseinrichtung 40 dargestellt ist. Der Verdampfer ist unmittelbar unterhalb der Luftfördereinrichtung 20 angeordnet ist und insbesondere noch oberhalb der ersten Durchtrittsöffnung 30.

Die Luftfördereinrichtung 20 erzwingt eine auf der Rückseite des Rahmens 10 von oben nach unten gerichtete Luftströmung 34, von der Teilluftströme 42, 44, 46 abgezweigt werden, die über beispielsweise die Durchtrittsöffnung 30 von der Rückseite des Rahmens 10 auf die Vorderseite hindurchtreten, auf der die elektrischen Geräte 2, 4, 6 angeordnet sind. Auf der Vorderseite vereinigen sich die Teilluftströme zu einer vorderseitigen Gesamtluftströmung. Der durch die Durchtrittsöffnung 30 hindurchtretende Teilluftstrom 42 überstreicht dabei das Gerät 2, dem die Durchtrittsöffnung 30 zugeordnet ist, noch bevor sich der Teilluftstrom 42 auf der Vorderseite des Rahmens 10 mit den weiteren Teilluftströmen 44, 46 vereinigt. Oberhalb der Geräte 2, 4, 6 wird die vorderseitige Gesamtluftströmung von der Luftfördereinrichtung 20 eingesaugt und über die Luftkühleinrichtung 40 wieder auf die Rückseite transportiert.

Oberhalb des ersten Montagestegs 12 ist ein Befestigungselement 48 angeordnet, an dem die Luftfördereinrichtung 20 und/oder die Luftkühlungseinrichtung 40 montiert sind. Ein erster Stegzwischenraum zwischen den Befestigungselement 48 und dem ersten Montagesteg 12 ist mittels eines den Rahmen 10 an dieser Stelle im Wesentlichen Luftdicht abschließenden Deckelelements 36 verschlossen. Dagegen ist in dem Stegzwischenraum zwischen den ersten Montagesteg 12 und dem zweiten Montagesteg 14 ein erstes Deckelelement 32 angeordnet, das die Durchtrittsöffnung 30 aufweist. Das erste Deckelelement 32 kann dabei in die von den Verdrahtungskämmen 28 begrenzten Seitenränder des Stegzwischenraums einsteckbar sein. Die Durchtrittsöffnung 30 kann dabei in dem ersten Deckelelement 32 vorgegeben sein, oder das erste Deckelelement 32 kann durch lokale Materialausdünnung, Perforation oder dergleichen Sollbruchstellen aufweisen, mittels denen die Durchtrittsöffnung 30 einfach und vorzugsweise werkzeuglos herstellbar ist.

Da das zweite Gerät 4 eine vergleichsweise große Bauhöhe aufweist, ist in den Stegzwischenraum zwischen dem zweiten Montagesteg 14 und dem dritten Montagesteg 16 ein zweites Deckelelement 38 eingesetzt, in dessen Durchtrittsöffnung ein Luftleitelement 50 eingesetzt ist, vorzugsweise lösbar eingesteckt ist, mittels dem die hindurch tretende kühlende Luft gezielt an das vordere Ende des zweiten Geräts 4 zuführbar ist. In entsprechender Weise kann das Luftleitelement 50 die kühlende Luft alternativ oder ergänzend auch in horizontaler Richtung verteilen.

Unterhalb des dritten Montagestegs 16 ist eine sich über die gesamte Breite des dritten Montagestegs 16 erstreckende Durchtrittsöffnung angeordnet, über welche der verbleibende Luftstrom 34 von der Rückseite auf die Vorderseite des Rahmens 10 hindurch treten kann und zunächst über das dritte Gerät 16 kühlend streichen kann und anschließend nach oben in Richtung auf die Luftfördereinrichtung 20 abgesaugt wird.

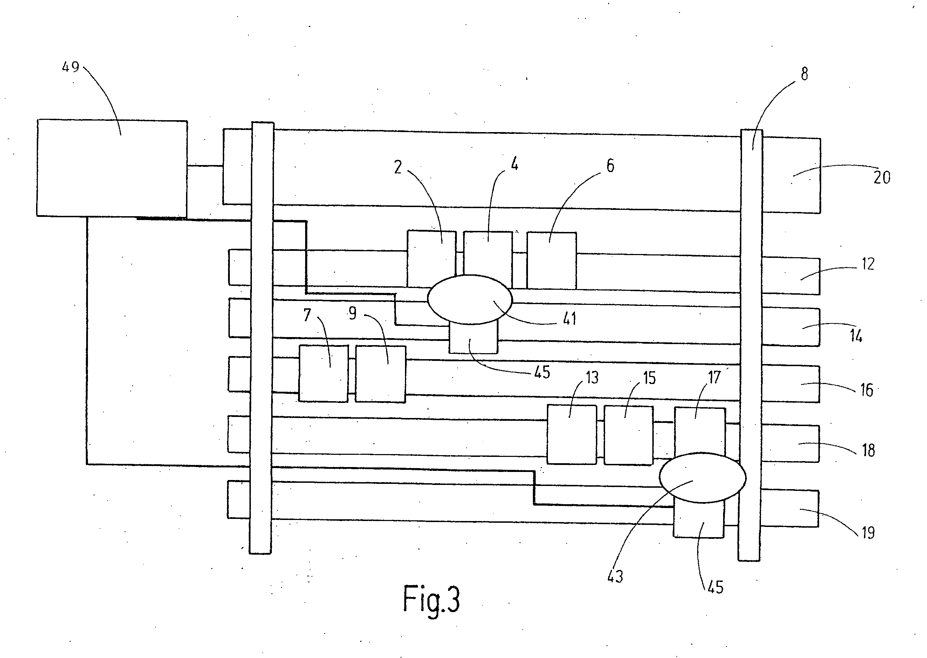

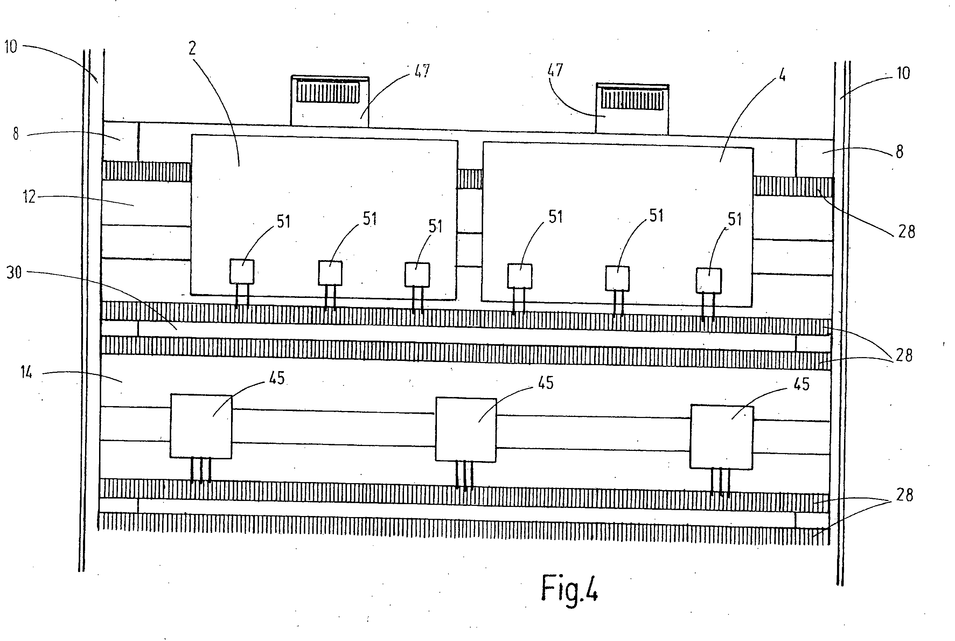

Unter Bezug auf die Fig. 3 und 4 wird die erfindungsgemäße Klimatisierungsanordnung anhand von Beispielen erläutert, bei denen der Schaltschrank 1 an sich dem Stand der Technik entspricht, wie es in Fig. 1 und 2 dargestellt ist. Die Fig. 3 zeigt diesbezüglich ein Ausführungsbeispiel, bei dem an den Tragschienen 8 fünf Montagestege angebracht sind, die von oben nach unten mit 12, 14, 16, 18 und 19 bezeichnet sind. Als Beispiel für eine mögliche Lageanordnung oder örtliche Verteilung von Geräten sind bei dem Beispiel von Fig. 3 an dem obersten, ersten Montagesteg 12 drei Geräte 2, 4 und 6 nebeneinander angeordnet, der dritte Montagesteg 16 trägt zwei Geräte 7 und 9 in Nebeneinanderanordnung, während an dem vierten Montagesteg 18 drei Geräte 13, 15 und 17 nebeneinanderliegend angeordnet sind. Ihrer Art und ihrer Betriebsweise entsprechend erzeugen die Geräte Verlustwärme in unterschiedlichem Ausmaß. Beispielsweise ist die Erzeugung von Verlustwärme bei Bauelementen der Leistungselektronik höher als bei Bauelementen wie Sensoren oder Relais in Steuerleitungen. Bei dem in Fig. 3 gezeigten Beispiel entwickeln von den am ersten Montagesteg 12 befindlichen Geräten die Geräte 2 und 4 eine größere Menge an Verlustwärme, während Geräte 7 und 9 am dritten Montagesteg 16, ebenso wie Geräte13 und 15 am vierten Montagesteg 18 Verlustwärme in geringerem Maße entwickeln. Das Gerät 17 am vierten Montagesteg 18 erzeugt demgegenüber wieder Verlustwärme in größerem Maße. Bei der beim Stand der Technik zur Verfügung stehenden passiven Entwärmung mittels der zwischen Montagestegen hindurchtretenden Teilluftströme 42, 44 und 46 würde sich bei dieser Geräteverteilung an den Geräten 2 und 4 sowie am Gerät 17 im Betrieb ein Wärmenest 41 bzw. 43 ausbilden, wie in Fig. 3 mit ovalem Umriss symbolhaft angedeutet ist. Zur Vermeidung derartiger sog. Hot-Spots sieht die Erfindung eine aktive, punktuelle Intensiv-Klimatisierung, hier in Form der Intensivkühlung, vor, bewirkt durch je einen in geeigneter Lage angeordneten, elektrisch betreibbaren Lüfter 45. Durch eine gezielte, verstärkte Umströmung betreffender Geräte-Bereiche sind Wärmenester auflösbar oder verhinderbar. Die aus der Luftströmung 34 zur Verfügung stehende Klimatisierungsleistung lässt sich dadurch optimal nutzen, so dass auch in Fällen, wo Geräte mit erhöhter Verlustwärmeerzeugung verteilt angeordnet sind, ein gleichmäßiges Temperaturniveau innerhalb des Schaltschranks aufrechterhalten werden kann.

Als Lüfter 45 können beispielsweise mit Vorteil Einbaulüfter benutzt werden, die unter der Bezeichnung "STEGO JET SJ019" im Handel erhältlich und von der Firma STEGO Elektrotechnik GmbH, Kolpingstr. 21, 74523 Schwäbisch Hall, Deutschland, hergestellt sind. Solche Lüfter liefern bei einer Leistungsaufnahme von 4 Watt nur einen sehr geringen Verlustwärmeeintrag und ermöglichen eine gewünschte Ausrichtung des erzeugten Luftstrahls. Für einen bedarfsangepassten Betrieb sind die Lüfter 45 mittels einer elektronischen Steuereinrichtung 49 regelbar, die Signale von in Fig. 3 nicht dargestellten Temperatursensoren verarbeitet.

Die Fig. 4 verdeutlicht beispielhaft die Anordnung zweier Geräte 2 und 4 mit erhöhter Verlustwärmeerzeugung, die an einer Montageschiene 12 nebeneinanderliegend angebracht sind. Zur Vermeidung von Wärmenestern sind in diesem Fall an der benachbarten Montageschiene 14 drei Lüfter 45 angeordnet, deren Luftstrahl für eine optimale Umströmung der Geräte 2 und 4 ausrichtbar ist. Außerdem zeigt Fig. 4 zwei Temperatursensoren 47, die die Temperatur in oberhalb der Geräte 2, 4 liegenden Zonen erkennen und der Steuereinrichtung 49 Signale für die Leistungsregelung der Lüfter 45 zuführen. In der in der Schaltschranktechnik ähnlichen Weise sind die Verdrahtung der Anschlüsse 51 der Geräte 2, 4 sowie die Anschlussleitungen der Lüfter 45 über die an den Montageschienen befindlichen Verdrahtungskämme 28 zur rückseitigen Verdrahtungsseite des Schaltschranks geführt.

Bei der durch den Betrieb der Lüfter 45 erreichten Verbesserung der Klimatisierungswirkung kann bei einer ausreichenden, zur Verfügung stehenden passiven Kühlung des Luftstroms 34, beispielsweise durch Wärmeaustausch von Rückwand oder Seitenwänden des Schaltschranks 1 mit der Umgebungsluft, auf die Luftkühlungseinrichtung 40 verzichtet werden, oder es kann eine Luftkühlungseinrichtung 40 geringerer Leistung benutzt werden.

## Patentansprüche

1. Klimatisierungsanordnung, insbesondere Kühlanordnung, zumindest aufweisend einen Schaltschrank (1) mit einer horizontal verlaufende Montagestege (12, 14, 16,18, 19) aufweisenden Trageinrichtung (10), an deren Vorderseite, die Schaltschranktüren zugewandt ist, zu klimatisierende elektrische und/oder elektronische Geräte (2, 4, 6, 7, 9, 13, 15, 17) in Etagen über- und nebeneinander angeordnet sind, wobei eine Luftfördereinrichtung (20) vorgesehen ist, mit der auf der Rückseite der Trageinrichtung (10) eine Luftströmung (34) von oben nach unten erzwingbar ist, und wobei Teilluftströme (42, 44, 46) der Luftströmung (34) zwischen vertikal benachbarten Montagestegen (12, 14, 16, 18, 19) hindurch zur Vorderseite der Montagestege und zu an der Vorderseite der Montagestege angebrachten, zu klimatisierenden Geräten (2, 4, 6, 7, 9, 13, 15, 17) gelangen,
**dadurch gekennzeichnet,**
**dass** für eine gezielte, bereichsweise Verstärkung der Klimatisierungswirkung an zumindest einer ausgewählten, einem zu klimatisierenden Gerät (1, 4, 17) räumlich zugeordneten Stelle (41 bzw. 43) eine die Strömungsgeschwindigkeit des betreffenden Teilluftstroms aktiv erhöhende Einrichtung (45) vorgesehen ist;
**dass** als jeweilige, die Strömungsgeschwindigkeit erhöhende Einrichtung ein elektrisch betreibbarer Lüfter (45) vorgesehen ist; und
**dass** die Temperatur der Umgebungszone der ausgewählten Geräte (2, 4, 17) erkennende Temperatursensoren (47) und eine die Leistung zugeordneter Lüfter (45) in Abhängigkeit von der erkannten Zonentemperatur regelnde Steuereinrichtung (49) vorgesehen sind.

2. Klimatisierungsanordnung nach Anspruch 1, **dadurch gekennzeichnet, dass** jeweilige Lüfter (45) an Montagestegen (14, 19) unterhalb ausgewählter Geräte (2, 4, 17) angeordnet sind.

3. Klimatisierungsanordnung nach Anspruch 1 oder 2, **dadurch gekennzeichnet, dass** die Zwischenräume zwischen benachbarten Montagestegen (12, 14, 16) zumindest teilweise durch Verschlussteile (22, 24, 26) geschlossen sind und dass in diesen Durchtrittsöffnungen (30) für Teilluftströme in räumlicher Zuordnung zu den zu klimatisierenden Geräten (24, 17) und zu jeweiligen Lüftern (45) gebildet sind.

4. Klimatisierungsanordnung nach einem der vorstehenden Ansprüche, **dadurch gekennzeichnet, dass** die zwischen benachbarten Montagestegen freigelassenen Zwischenräume die Durchtrittsöffnung (30) für Teilluftströme bilden.

5. Klimatisierungsanordnung nach einem der vorstehenden Ansprüche, **dadurch gekennzeichnet, dass** elektrische Leitungen der Verdrahtung der Geräte (24) sowie die Anschlussleitungen der jeweiligen Lüfter (45) über Verdrahtungskämme (28), die sich an den Zwischenraum zwischen Montagestegen (12, 14) begrenzenden Seitenrändern befinden, zu der die Verdrahtungsseite bildenden Rückseite der Trageinrichtung (10) geführt sind.

6. Klimatisierungsanordnung nach einem der vorstehenden Ansprüche, **dadurch gekennzeichnet, dass** eine oberhalb des obersten Montagesteges (12) angeordnete, der Luftfördereinrichtung (20) nachgeschaltete Luftkühlungseinrichtung (40) vorgesehen ist.

## Claims

1. Air-conditioning assembly, in particular a cooling assembly, at least comprising a control cabinet (1) having a support device (10) with horizontally extending mounting strips (12, 14, 16, 18, 19), on the front of which support device, directed towards the control cabinet doors, electrical and/or electronic devices (2, 4, 6, 7, 9, 13, 15, 17) to be air-conditioned are arranged in tiers above and next to each other, wherein an air conveying device (20) is provided, by means of which an air flow (34) can be forced from top to bottom on the rear of the support device (10), and wherein partial air flows (42, 44, 46) of the air flow (34) pass between vertically adjacent mounting strips (12, 14, 16, 18, 19) to the front of the mounting strips and to devices (2, 4, 6, 7, 9, 13, 15, 17) to be air-conditioned which are mounted on the front of said mounting strips, **characterised in that**
a device (45) which actively increases the flow velocity of the partial air flow concerned is provided at at least one selected point (41 or 43), which is spatially assigned to a device (1, 4, 17) to be air-conditioned, for targeted, area by area intensification of the air-conditioning effect;
an electrically operable fan (45) is provided as the respective device increasing the flow velocity; and
the temperature sensors (47) detecting the temperature of the surrounding zone of the selected devices (2, 4, 17) and a control device (49) regulating the power of assigned fans (45) as a function of the zone temperature detected are provided.

2. Air-conditioning assembly according to claim 1, **characterised in that** respective fans (45) are arranged on mounting strips (14, 19) below selected devices (2, 4, 17).

3. Air-conditioning assembly according to claim 1 or 2, **characterised in that** the gaps between adjacent mounting strips (12, 14, 16) are closed at least in part by closure parts (22, 24, 26) and **in that** openings (30) for partial air flows are formed in spatial assignment to the devices (2, 4, 17) to be air-conditioned and to respective fans (45).

4. Air-conditioning assembly according to one of the preceding claims, **characterised in that** the gaps left free between adjacent mounting strips form the opening (30) for partial air flows.

5. Air-conditioning assembly according to one of the preceding claims, **characterised in that** electrical cables for the wiring of the devices (2, 4) and the connecting cables of the respective fans (45) are routed to the rear of the support device (10), which forms the wiring side, via wiring combs (28) which are located in the gap between side edges bounding the mounting strips (12, 14).

6. Air-conditioning assembly according to one of the preceding claims, **characterised in that** an air cooling device (40) is provided which is arranged above the uppermost mounting strip (12) and is downstream of the air conveying device (20).

## Revendications

1. Système de conditionnement d'air, notamment système de refroidissement, comportant au moins une armoire (1) de commande ayant un dispositif (10) de support, qui comporte des entretoises (12, 14, 16, 18, 19) de montage, s'étendant horizontalement, et au côté avant duquel, qui est tourné vers les portes de l'armoire de commande, sont disposés en étages, les uns sur les autres et les uns à côté des autres, des appareils (2, 4, 6, 7, 9, 13, 15, 17) électriques et/ou électroniques à conditionner, dans lequel il est prévu un dispositif (20) de refoulement de l'air, par lequel, du côté arrière du dispositif (10) de support, un écoulement (34) d'air peut être forcé de haut en bas, et dans lequel des courants (42, 44, 46) d'air partiels de l'écoulement (34) d'air arrivent, en passant à travers des entretoises (12, 14, 16, 18, 19) de montage voisines verticalement, au côté avant des entretoises de montage et à des appareils (2, 4, 6, 7, 9, 13, 15, 17) à conditionner montés sur le côté avant des entretoises de montage,
**caractérisé**
pour un renforcement ciblé endroit par endroit de l'effet de conditionnement d'air, il est prévu, sur au moins un point (41 respectivement 43) sélectionné et associé dans l'espace à un appareil (1, 4, 17) à conditionner, un dispositif (45) augmentant activement la vitesse d'écoulement du courant d'air partiel concerné ;
**en ce qu'**il est prévu, comme dispositif respectif augmentant la vitesse de l'écoulement, un ventilateur (45) pouvant fonctionner électriquement ; et
**en ce qu'**il est prévu des sondes (47) de température détectant la température de la zone ambiante des appareils (2, 4, 17) sélectionnés et un dispositif (49) de commande réglant la puissance des ventilateurs (45) associés en fonction de la température de la zone détectée.

2. Système de conditionnement d'air suivant la revendication 1, **caractérisé en ce que** des ventilateurs (45) respectifs sont montés sur des entretoises (14, 19) de montage en-dessous des appareils (2, 4, 17) sélectionnés.

3. Système de conditionnement d'air suivant la revendication 1 ou 2, **caractérisé en ce que** les espaces intermédiaires entre deux entretoises (12, 14, 16) de montage voisines sont fermées au moins en partie par des pièces (22, 24, 26) de fermeture, et **en ce qu'**il est formé dans celles-ci des ouvertures (30) de passage de courants d'air partiels en association dans l'espace avec les appareils (24, 17) à conditionner et avec les ventilateurs (45) respectifs.

4. Système de conditionnement d'air suivant l'une des revendications précédentes, **caractérisé en ce que** les espaces intermédiaires, laissés libres entre des entretoises de montage voisines, forment l'ouverture (30) de passage des courants d'air partiels.

5. Système de conditionnement d'air suivant l'une des revendications précédentes, **caractérisé en ce que** des lignes électriques de câblage des appareils (24) ainsi que les lignes de connexion des ventilateurs (45) respectifs sont, par des peignes (28) de câblage, qui se trouvent sur des bords latéraux délimitant l'espace intermédiaire entre des entretoises (12, 14) de montage, guidés vers le côté arrière, formant le côté de câblage, du dispositif (10) de support.

6. Système de conditionnement d'air suivant l'une des revendications précédentes, **caractérisé en ce qu'**il est prévu un dispositif (40) de refroidissement de l'air, monté au-dessus de l'entretoise (12) de montage la plus haute et monté en aval du dispositif (20) de refoulement de l'air.
